# EUROPÄISCHE PATENTSCHRIFT

(11) **EP 1 997 227 B1**
(45) Veröffentlichungstag und Bekanntmachung des Hinweises auf die Patenterteilung: **22.07.2009**
(21) Anmeldenummer: 07723219.7
(22) Anmeldetag: 13.03.2007
(51) Int. Cl.: H03K 5/156

(54) **SCHALTUNGSANORDNUNG UND VERFAHREN ZUM BEREITSTELLEN EINES TAKTSIGNALS MIT EINEM EINSTELLBAREN TASTVERHÄLTNIS**
CIRCUIT ARRANGEMENT AND METHOD FOR PROVIDING A CLOCK SIGNAL WITH AN ADJUSTABLE DUTY RATIO
DISPOSITIF DE COMMUTATION ET PROCÉDÉ DE PRÉPARATION D'UN SIGNAL D'HORLOGE AVEC UN RAPPORT IMPULSION/PAUSE RÉGLABLE

(30) Priorität: 13.03.2006 DE 102006011448
(43) Veröffentlichungstag der Anmeldung: 03.12.2008
(73) Patentinhaber: Austriamicrosystems AG, 8141 Unterpremstätten (AT)
(72) Erfinder: DENIER, Urs, 8645 Jona (CH)
(74) Vertreter: Epping - Hermann - Fischer
(86) Internationale Anmeldenummer: PCT/EP2007/002209
(87) Internationale Veröffentlichungsnummer: WO 2007/104534

(56) Entgegenhaltungen:
- EP-A- 0 155 041
- WO-A-99/56385
- DE-A1- 19 822 374
- JP-A- 59 008 112
- US-A- 4 479 216
- US-B1- 6 169 765
- US-B1- 6 320 438
- "PRODUIRE UN RAPPORT CYCLIQUE DE 50% PRECIS A 20 MHZ" ELECTRONIQUE, CEP COMMUNICATION, PARIS, FR, Nr. 90, März 1999 (1999-03), Seite 88,90, XP000894138 ISSN: 1157-1152

## Beschreibung

Die vorliegende Erfindung betrifft eine Schaltungsanordnung zum Bereitstellen eines Taktsignals mit einem einstellbaren Tastverhältnis, deren Verwendung und ein Verfahren zum Bereitstellen eines Taktsignals mit einem einstellbaren Tastverhältnis.

Oszillatoren und insbesondere Schwingquarzoszillatoren sind weit verbreitete Schaltkreise, um Mikroprozessoren und Speicherbausteine mit einem Taktsignal zu versorgen. Dabei wird häufig ein genaues Tastverhältnis gefordert. Das Tastverhältnis eines Taktsignals wird üblicherweise als das Verhältnis der Zeit, während der sich das Taktsignal auf einem Pegel "High" befindet, zu einer Periodendauer des Taktsignals definiert.

Das Dokument "High-Performance Crystal Oscillator Circuits: Theory and Application", Autoren E. Vittoz, M. Degrauwe, S. Bitz, IEEE Journal of Solid-State Circuits, Band 23, Nummer 3, Juni 1988, pp. 774 bis 783 beschreibt ein Ersatzschaltbild eines Schwingquarzes und einen Schwingquarzschaltkreis.

Das Dokument US 4,959,557 befasst sich mit einem Schaltkreis mit einem Vorwärts- und einem Rückkopplungszweig zur Kontrolle des Tastverhältnisses eines Taktsignals.

Das Dokument US 5,481,228 beschreibt eine Anordnung zur Steuerung des Tastverhältnisses mit seriell geschalteten Transistorstufen.

Aufgabe der vorliegenden Erfindung ist es, eine Schaltungsanordnung und ein Verfahren zum Bereitstellen eines Taktsignals anzugeben, die eine genaue Einstellung des Tastverhältnisses des Taktsignals ermöglichen.

Diese Aufgabe wird mit dem Gegenstand gemäß Patentanspruch 1 sowie dem Verfahren gemäß Patentanspruch 13 gelöst. Weiterbildungen und Ausgestaltungen sind jeweils Gegenstand der abhängigen Ansprüche.

Erfindungsgemäß umfasst eine Schaltungsanordnung zum Bereitstellen eines Taktsignals mit einem einstellbaren Tastverhältnis eine Verstärkerschaltung, einen Tiefpass und eine Integratorschaltung. Die Verstärkerschaltung ist an einem ersten Eingang mit einem Eingang der Schaltungsanordnung verbunden. Die Verstärkerschaltung ist an einem Ausgang mit einem Ausgang der Schaltungsanordnung gekoppelt. Der Tiefpass ist eingangsseitig mit dem Ausgang der Verstärkerschaltung und ausgangsseitig mit der Integratorschaltung verbunden. Die Integratorschaltung wiederum ist ausgangsseitig mit einem zweiten Eingang der Verstärkerschaltung verbunden.

Der Eingang der Schaltungsanordnung dient zum Anschließen eines Oszillators. Eine Oszillatorspannung wird dem Eingang der Schaltungsanordnung zugeleitet. An dem Ausgang der Schaltungsanordnung ist ein Taktsignal mit einem Tastverhältnis abgreifbar. Ein an dem Ausgang der Verstärkerschaltung anliegendes Signal wird dem Tiefpass zugeführt. Ein ausgangsseitig an dem Tiefpass abgreifbares Signal wird der Integratorschaltung zugeleitet. Die Integratorschaltung ist zur Abgabe eines vorgebbaren Schwellwerts zur Steuerung des Tastverhältnisses ausgelegt. Dieser Schwellwert wird dem zweiten Eingang der Verstärkerschaltung zugeleitet. Die Verstärkerschaltung gibt ausgangsseitig ein Signal ab, das in Abhängigkeit von dem Oszillatorsignal und dem Schwellwert bereitgestellt wird.

Das von der Verstärkerschaltung bereitgestellten Signal wird somit über den Tiefpass und die Integratorschaltung auf den zweiten Eingang der Verstärkerschaltung zurückgekoppelt. Der Tiefpass stellt ein Signal bereit, dass in erster Näherung als Gleichsignal ausgebildet ist und einem Wert des Tastverhältnisses entspricht. Mittels der Rückkopplung wird bei einer Änderung des Tastverhältnisses, die beispielsweise durch eine Störung in der Oszillatorspannung oder durch eine ausgangsseitig ankoppelbare elektrische Last verursacht wird, gegengesteuert, so dass wieder das Tastverhältnis vor der Störung erzielt wird.

Mit Vorteil ist mittels des von der Integratorschaltung bereitgestellten Schwellwertes ein Schwellwert der Verstärkerschaltung einstellbar. Es ist ein Vorteil der Schaltungsanordnung, dass eine Phase des Taktsignals nahezu identisch mit einer Phase des Oszillatorsignals ist.

In einer Weiterbildung weist die Verstärkerschaltung einen Komparator auf, der an einem ersten und an einem zweiten Eingang mit dem ersten beziehungsweise dem zweiten Eingang der Verstärkerschaltung verbunden ist. Der Komparator kann an einem Ausgang mit dem Ausgang der Verstärkerschaltung verbunden sein. Mit Vorteil kann ein Puffer zur Verbindung des Ausgangs des Komparators mit dem Ausgang der Verstärkerschaltung vorgesehen sein.

In einer alternativen Weiterbildung weist die Verstärkerschaltung einen Puffer mit einem Eingang auf, der mittels eines Einkoppelkondensators mit dem ersten Eingang der Verstärkerschaltung verbunden ist. Der Puffer ist an dem Eingang weiterhin mit dem zweiten Eingang der Verstärkerschaltung und ausgangsseitig mit dem Ausgang der Verstärkerschaltung verbunden.

Der Puffer kann einen Inverter aufweisen. Alternativ kann der Puffer einen ersten Inverter und einen zweiten Inverter umfassen, wobei der zweite Inverter dem ersten Inverter nachgeschaltet ist. Dabei kann die Stromtreiberfähigkeit des zweiten Inverters größer als die Stromtreiberfähigkeit des ersten Inverters sein. In einer Ausführungsform dieser Weiterbildung kann ein Weite zu Länge-Verhältnis des P-Kanal Feldeffekttransistors des zweiten Inverters größer als ein Weite zu Länge-Verhältnis des P-Kanal Feldeffekttransistors des ersten Inverters und entsprechend ein Weite zu Länge-Verhältnis des N-Kanal-Feldeffekttransistors des zweiten Inverters größer als ein Weite zu Länge-Verhältnis des N-Kanal Feldeffekttransistors des ersten Inverters sein. Dies verbessert die Treiberfähigkeit.

Der Puffer kann mehr als zwei Inverter umfassen. Mit Vorteil verursacht eine geradzahlige Anzahl von Invertern nahezu keine Phasenverschiebung in der Verstärkerschaltung. Mit Vorteil kann mittels des ersten Inverters beziehungsweise der zwei oder mehr Inverter ein dem Puffer zugeführtes Signal in ein Rechtecksignal umgewandelt werden, welches als das Taktsignal abgegeben wird. Das Taktsignal liegt somit als wertdiskretes, bevorzugt digitales Signal vor.

Die Verstärkerschaltung kann dazu ausgelegt sein, ausgangsseitig ein Rechtecksignal als Taktsignal bereitzustellen.

In einer bevorzugten Ausführungsform umfasst die Verstärkerschaltung den ersten Eingang, den zweiten Eingang, den Komparator, dessen Eingänge den ersten und den zweiten Eingang der Verstärkerschaltung bilden, den Puffer, der den ersten Inverter aufweist und den Ausgang des Komparators mit dem Ausgang der Verstärkerschaltung koppelt, und den Ausgang der Verstärkerschaltung.

In einer Ausführungsform weist die Integratorschaltung einen Transkonduktanz-Verstärker auf. Der Transkonduktanz-Verstärker ist an einem ersten Eingang mit dem Tiefpass und an einem Ausgang mit dem zweiten Eingang der Verstärkerschaltung gekoppelt. Dem Transkonduktanz-Verstärker ist an einem zweiten Eingang eine Referenzspannung zuführbar. Die Referenzspannung kann der Schaltungsanordnung über einen Eingang der Schaltungsanordnung zugeführt sein oder intern erzeugt werden.

In einer alternativen Ausführungsform weist die Integratorschaltung einen Operationsverstärker auf. Der Operationsverstärker ist an einem invertierenden Eingang mit dem Tiefpass verbunden. Einem nichtinvertierenden Eingang des Operationsverstärkers ist die Referenzspannung zuführbar. Der Operationsverstärker ist an einem Ausgang mit dem zweiten Eingang der Verstärkerschaltung und über einen Rückkoppelkondensator mit dem invertierenden Eingang des Operationsverstärkers gekoppelt.

Die Referenzspannung kann bevorzugt eine konstante Spannung oder Gleichspannung sein. Die Referenzspannung ist bevorzugt wechselspannungsfrei. Die Integratorschaltung weist bevorzugt eine Gleichspannungsquelle zum Bereitstellen der Referenzspannung auf. Das Tastverhältnis hängt von der Referenzspannung ab, da ein Wert der Referenzspannung zum Einstellen des Schwellwertes und damit des Tastverhältnisses dient.

In einer Weiterbildung weist die Gleichspannungsquelle der Integratorschaltung einen Spannungsteiler mit einem ersten und einem zweiten Widerstand auf, der zwischen einen Versorgungsspannungsanschluss und einen Bezugspotenzialanschluss geschaltet ist. Ein Abgriff des Spannungsteilers zwischen den beiden Widerständen ist mit dem zweiten Eingang des Transkonduktanz-Verstärkers beziehungsweise dem nichtinvertierenden Eingang des Operationsverstärkers verbunden. Am Abgriff des Spannungsteilers kann die Referenzspannung bereitgestellt werden. Bevorzugt sind für ein Tastverhältnis 1/2 der erste und der zweite Widerstand mit demselben Widerstandswert ausgelegt.

Der erste Widerstand und der zweite Widerstand des Spannungsteilers können als Widerstandsnetzwerk mit mehreren Abgriffen ausgebildet sein. Zwischen den Abgriffen kann zum Einstellen der Referenzspannung auf verschiedene Werte umgeschaltet werden. Der von der Integratorschaltung bereitgestellte Schwellwert wird in Abhängigkeit von der Referenzspannung abgegeben.

In einer alternativen Ausführungsform kann anstelle des Spannungsteilers eine Switched-Capacitor-Schaltung vorgesehen sein, welche von der Gleichspannungsquelle umfasst ist. Die Switched-Capacitor-Schaltung umfasst einen ersten und einen zweiten Schaltkondensator, die in Serie zwischen einen Versorgungsspannungsanschluss und einen Bezugspotenzialanschluss geschaltet sind, und einen Abgriff zwischen dem ersten und dem zweiten Schaltkondensator. Der Abgriff der Switched-Capacitor-Schaltung ist mit dem zweiten Eingang des Transkonduktanz-Verstärkers beziehungsweise dem nichtinvertierenden Eingang des Operationsverstärkers verbunden. Die an dem Abgriff bereitgestellte Referenzspannung kann in erster Näherung unabhängig von einem Wert des ersten und einem Wert des zweiten Schaltkondensators sein und näherungsweise die Hälfte der Versorgungsspannung betragen. Mit Vorteil verbindet ein Haltekondensator den Abgriff der Switched-Capacitor-Schaltung mit dem Bezugspotenzialanschluss.

Der Tiefpass, der zwischen den Ausgang der Verstärkerschaltung und den Eingang der Integratorschaltung geschaltet ist, kann als Tiefpass erster Ordnung ausgebildet sein und einen Widerstand und einen Kondensator aufweisen. Alternativ kann er als Tiefpass höherer Ordnung realisiert sein. Er kann als Transkonduktanz-Verstärker C-Filter ausgebildet sein. Mittels eines Regelkreises, umfassend die Verstärkerschaltung, den Tiefpass und die Integratorschaltung, kann vorteilhaft ein Tastverhältnis des Taktsignals genau eingestellt werden.

Der ankoppelbare Oszillator kann ein Schwingquarzoszillator sein. Der Schwingquarzoszillator kann als Pierceschaltung realisiert sein. Alternativ kann der Oszillator als Ringoszillator ausgebildet sein. Der Oszillator kann als Relaxations-Oszillator realisiert sein. Der Relaxations-Oszillator kann als LC-Oszillator oder bevorzugt als RC-Oszillator ausgebildet sein.

Die Schaltungsanordnung kann auf einem Halbleiterkörper realisiert sein. In einer alternativen Ausführung kann zusätzlich auch eine Beschaltung eines Schwingquarzes auf dem Halbleiterkörper realisiert sein.

Die Schaltungsanordnung kann in einem Mikroprozessorschaltkreis oder einem Halbleiterspeicherbaustein eingesetzt sein.

Erfindungsgemäß sieht ein Verfahren zum Bereitstellen eines Taktsignals mit einem einstellbaren Tastverhältnis folgende Schritte vor: Ein Oszillatorsignal wird einer Verstärkerschaltung zugeführt. In Abhängigkeit eines Schwellwerts wird das Oszillatorsignal verarbeitet. Das verarbeitete Oszillatorsignal wird ausgangsseitig als Taktsignal mit dem Tastverhältnis bereitgestellt. Aus dem Tastverhältnis wird ein Signal abgeleitet. Das aus dem Tastverhältnis abgeleitete Signal wird mit einer vorgebbaren Referenzspannung verglichen und der Schwellwert wird in Abhängigkeit des Vergleichsergebnisses bereitgestellt.

Mit Vorteil sind somit mittels einer Referenzspannung der Schwellwert und damit das Tastverhältnis einstellbar.

Bevorzugt wird eine Signalverarbeitung des Oszillatorsignals in Abhängigkeit des Schwellwerts mittels Vergleichen des Oszillatorsignals und des Schwellwerts, Verstärken des Vergleichsergebnisses und Bereitstellen des verstärkten Vergleichsergebnisses als das Taktsignal mit dem Tastverhältnis durchgeführt. Das Taktsignal mit dem Taktverhältnis wird in Abhängigkeit des Oszillatorsignals und des Schwellwerts eingestellt. Dabei ist das Taktsignal bevorzugt ein wertdiskretes Signal.

Die Erfindung wird nachfolgend an mehreren Ausführungsbeispielen anhand der Figuren näher erläutert. Funktions- beziehungsweise wirkungsgleiche Bauelemente tragen gleiche Bezugszeichen. In soweit sich Schaltungsteile oder Bauelemente gleichen, wird deren Beschreibung nicht in jeder der folgenden Figuren wiederholt.
- Figur 1: zeigt eine beispielhafte Ausführungsform der Schaltungsanordnung als Blockschaltbild nach dem vorgeschlagenen Prinzip,
- Figuren 2A und 2B: zeigen beispielhafte Ausführungsformen von Schaltungsanordnungen nach dem vorgeschlagenen Prinzip,
- Figur 3: zeigt beispielhafte Signalverläufe einer Schaltungsanordnung nach dem vorgeschlagenen Prinzip in Abhängigkeit von der Zeit,
- Figuren 4A bis 4D: zeigen eine beispielhafte Ausführungsform einer Switched-Capacitor-Schaltung,
- Figur 5: zeigt eine beispielhafte Ausführungsform eines ersten und eines zweiten Inverters,
- Figur 6: zeigt eine beispielhafte Ausführungsform eines Operationsverstärkers und
- Figuren 7A bis 7B: zeigen eine beispielhafte Ausführungsform eines getakteten Transkonduktanz-Verstärkers.

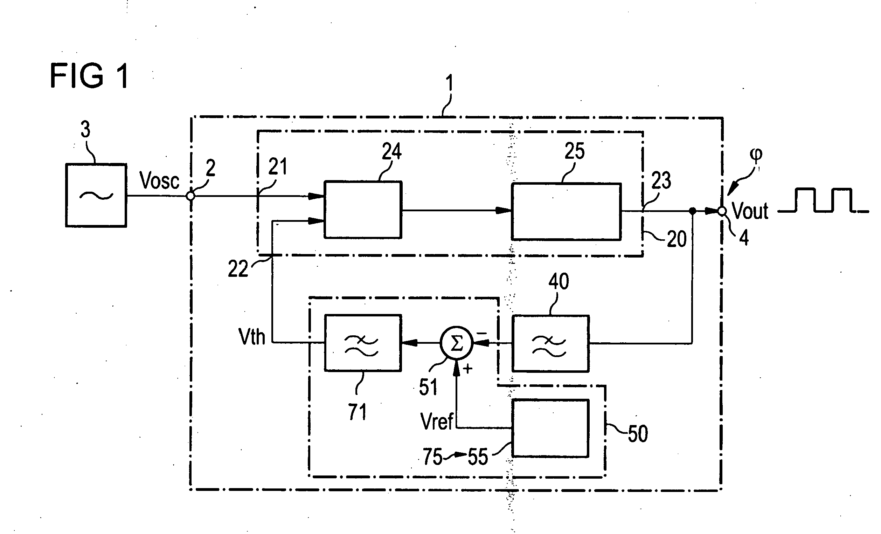

Figur 1 zeigt eine beispielhafte Ausführungsform einer Schaltungsanordnung als Blockschaltbild nach dem vorgeschlagenen Prinzip. Die Schaltungsanordnung 1 umfasst eine Verstärkerschaltung 20, einen Tiefpass 40 und eine Integratorschaltung 50. Die Schaltungsanordnung 1 weist darüber hinaus einen Eingang 2 auf, der mit dem Oszillator 3 verbunden ist. Die Schaltungsanordnung 1 umfasst ferner einen Ausgang 4 zur Abgabe eines Taktsignals Vout. Die Verstärkerschaltung 20 ist an einem ersten Eingang 21 mit dem Eingang 2 der Schaltungsanordnung 1 und an einem Ausgang 23 mit dem Ausgang 4 der Schaltungsanordnung 1 sowie mit einem Eingang des Tiefpasses 40 verbunden. Die Integratorschaltung 50 ist eingangsseitig mit dem Tiefpass 40 und ausgangsseitig mit einem zweiten Eingang 22 der Verstärkerschaltung verbunden. Die Verstärkerschaltung 20 weist einen Komparator 24 auf, der eingangsseitig mit dem ersten und dem zweiten Eingang 21, 22 der Integratorschaltung 20 gekoppelt ist. Ausgangsseitig ist der Komparator 24 mit dem Ausgang 23 der Verstärkerschaltung 20 gekoppelt. Ein Puffer 25 ist zwischen den Komparator 24 und den Ausgang 23 der Verstärkerschaltung 20 geschaltet. Die Integratorschaltung 50 umfasst einen Transkonduktanz-Verstärker 51, eine Gleichspannungsquelle 75, welche einen Spannungsteiler 55 aufweist, und ein Schleifenfilter 71. Der Transkonduktanz-Verstärker 51 ist eingangsseitig mit dem Tiefpass 40 und dem Spannungsteiler 55 verbunden. Ausgangsseitig ist der Transkonduktanz-Verstärker 51 über das Schleifenfilter 71 mit dem zweiten Eingang 22 der Verstärkerschaltung 20 verbunden.

Der Oszillator 3 stellt ausgangsseitig eine Oszillatorspannung Vosc bereit, die dem ersten Eingang 21 der Verstärkerschaltung 20 und damit dem Komparator 24 zugeleitet wird. Das Taktsignal Vout mit einem Taktverhältnis ϕ wird mittels des Komparators 24 in Abhängigkeit der Oszillatorspannung Vosc und einer Schwellspannung Vth, welche ausgangsseitig an der Integratorschaltung 50 abgreifbar ist, gebildet. Das Taktsignal Vout wird unter Verwendung des Tiefpasses 40 gefiltert, so dass ausgangsseitig am Tiefpass 40 ein Signal, welches das Taktverhältnis ϕ wiedergibt, abgreifbar ist. Dieses Signal wird mittels des Transkonduktanz-Verstärkers 51 mit einer Referenzspannung Vref, die ausgangsseitig am Spannungsteiler 55 abgreifbar ist, verglichen. Die Referenzspannung Vref ist eine Gleichspannung. Das Schleifenfilter 71 filtert ein am Transkonduktanz-Verstärker 51 ausgangsseitig abgreifbares Signal und führt es dem zweiten Eingang 22 der Schaltungsanordnung 1 zu.

Mit Vorteil wird das Tastverhältnis ϕ des Taktsignals Vout entsprechend der Referenzspannung mittels der Schaltungsanordnung 1 eingestellt. Mit Vorteil bilden die Verstärkerschaltung 20, der Tiefpass 40 und die Integratorschaltung 50 einen Regelkreis.

Anstelle des Spannungsteilers 55 kann in einer alternativen Ausführungsform eine Switched-Capacitor-Schaltung 59 als Gleichspannungsquelle 75 vorgesehen sein, die ausgangsseitig die Referenzspannung Vref bereitstellt.

In einer alternativen Ausführungsform kann anstelle des Transkonduktanz-Verstärkers 51 ein Operationsverstärker 65 mit einem invertierenden und einem nichtinvertierenden Eingang 66, 67 vorgesehen sein, die mit dem Ausgang des Tiefpasses 40 und eines Abgriffes des Spannungsteilers 55 gekoppelt sind.

Der Puffer 25 kann alternativ entfallen.

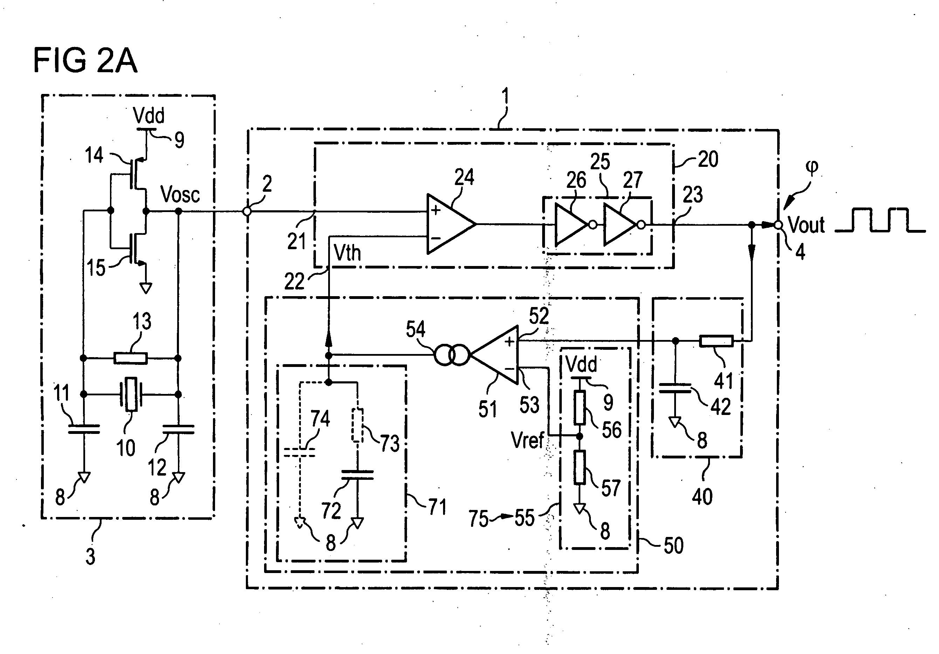

Figur 2A zeigt eine beispielhafte Ausführungsform einer Schaltungsanordnung nach dem vorgeschlagenen Prinzip anhand einer Weiterbildung des Blockschaltbilds von Figur 1. Der Oszillator 3 weist einen Schwingquarz 10 auf, der an einem ersten Anschluss über einen ersten Kondensator 11 und an einem zweiten Anschluss über einen zweiten Kondensator 12 mit einem Bezugspotenzialanschluss 8 verbunden ist. Der erste und der zweite Anschluss des Schwingquarzes 10 sind darüber hinaus über einen Widerstand 13 miteinander verbunden. Der erste Anschluss des Schwingquarzes 10 ist an einen Steueranschluss eines Inverters 14, 15 angeschlossen. Der Inverter weist einen P-Kanal Feldeffekttransistor 14 und einen N-Kanal Feldeffekttransistor 15 auf, die zwischen einen Versorgungsspannungsanschluss 9 und den Bezugspotenzialanschluss 8 geschaltet sind. Ein Abgriff zwischen den gesteuerten Strecken der beiden Transistoren 14, 15 ist mit dem zweiten Anschluss des Schwingquarzes 10 und dem Eingang 2 der Schaltungsanordnung 1 verbunden.

Der Tiefpass 40 umfasst einen Widerstand 41 und einen Kondensator 42. Der Widerstand 41 verbindet einen Eingang mit einem Ausgang des Tiefpasses 40 und der Kondensator 42 verbindet den Ausgang des Tiefpasses 40 mit dem Bezugspotenzialanschluss 8. Der Spannungsteiler 55, welcher von der Gleichspannungsquelle 75 umfasst ist, umfasst einen ersten und einen zweiten Widerstand 56, 57, die zwischen den Versorgungsspannungsanschluss 9 und den Bezugspotenzialanschluss 8 geschaltet sind. Ein Abgriff zwischen dem ersten und dem zweiten Widerstand 56, 57 ist an den zweiten Eingang 53 des Transkonduktanz-Verstärkers 51 angeschlossen. Der Tiefpass 40 ist ausgangsseitig an einen ersten Eingang 52 des Transkonduktanz-Verstärkers 51 angeschlossen. Ein Ausgang 54 des Transkonduktanz-Verstärkers 51 ist an dem zweiten Eingang 22 der Verstärkerschaltung 20 angeschlossen. Das Schleifenfilter 71 ist als Impedanz zwischen dem Ausgang 54 des Transkonduktanz-Verstärkers 51 und dem Bezugspotenzialanschluss 8 realisiert. Das Schleifenfilter 71 umfasst einen ersten Kondensator 74, der parallel zu einer Serienschaltung, aufweisend einen zweiten Kondensator 72 und einen ersten Widerstand 73, zwischen den Ausgang 54 des Transkonduktanz-Verstärkers 51 und den Bezugspotentialanschluss 8 geschaltet ist. Der Puffer 25 in der Verstärkerschaltung 20 umfasst eine Serienschaltung eines ersten und eines zweiten Inverters 26, 27.

Am Oszillator 3 ist ausgangsseitig die Oszillatorspannung Vosc abgreifbar. Der Komparator 24 vergleicht die Oszillatorspannung Vosc mit dem Schwellwert Vth, welcher von der Integratorschaltung 50 ausgangsseitig bereitgestellt wird. Der Komparator 24 gibt ausgangsseitig das Taktsignal Vout mit dem Tastverhältnis ϕ ab. Das Taktsignal Vout wird mittels des Tiefpasses 40 gefiltert, so dass an dem ersten Eingang 52 des Transkonduktanz-Verstärkers 51 ein näherungsweise konstantes Signal anliegt, welches das Tastverhältnis ϕ repräsentiert. Ein Strom am Ausgang 54 des Transkonduktanz-Verstärkers 51 wird in Abhängigkeit von dem gefilterten Signal und der Referenzspannung Vref, die an dem Abgriff zwischen den ersten und den zweiten Widerstand 56, 57 abgreifbar ist, gebildet. Der erste Eingang 52 des Transkonduktanz-Verstärkers 51 ist dabei als nichtinvertierender Eingang und der zweite Eingang 53 als invertierender Eingang ausgebildet. Die Integratorschaltung 50 stellt ausgangsseitig den Schwellwert Vth in Abhängigkeit von dem Strom am Ausgang 54 des Transkonduktanz-Verstärkers 51 und von einer Filtercharakteristik des Schleifenfilters 71 bereit. Das Schleifenfilter 71 ist als Tiefpass ausgebildet. Im Vorwärtszweig des Regelkreises ist ausschließlich die Verstärkerschaltung 20 vorgesehen, die nur eine geringe Phasenverzögerung aufweist. Im Rückkopplungszweig ist der Tiefpass 40 und die Integratorschaltung 50, umfassend das Schleifenfilter 71, vorgesehen. Der Tiefpass 40 und das Schleifenfilter 71 erzeugen eine Phasenverschiebung von jeweils bis zu 90 Grad. Aus der Verbindung der Integratorschaltung 50 mit dem invertierenden Eingang des Komparators 24 resultiert eine weitere Phasenverschiebung von näherungsweise 180 Grad, so dass die Phasenverschiebung im Regelkreis insgesamt 360 Grad beträgt.

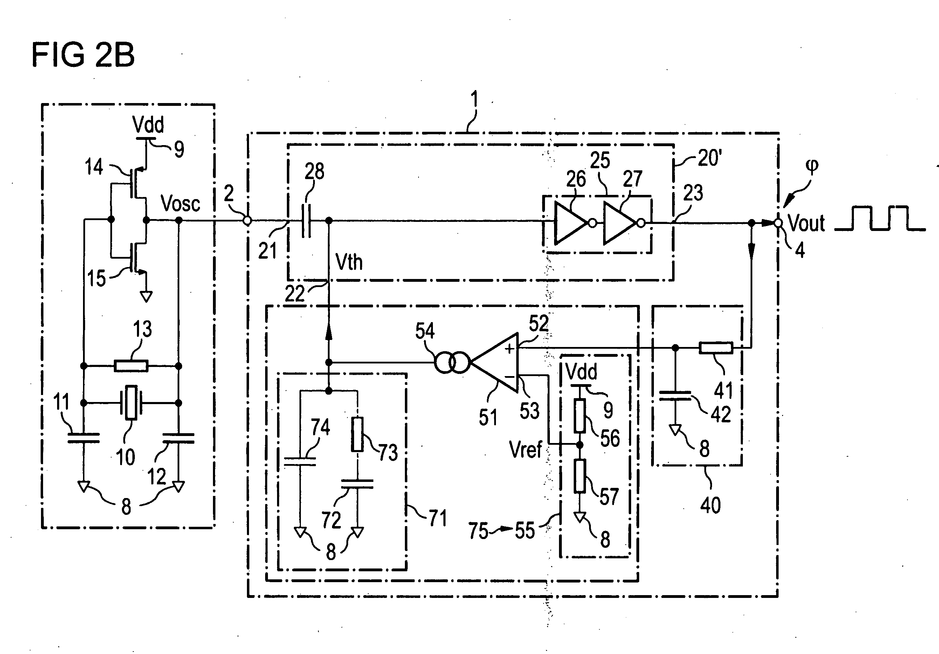

Figur 2B zeigt eine weitere beispielhafte Ausführungsform einer Schaltungsanordnung nach dem vorgeschlagenen Prinzip. Im Unterschied zur Schaltungsanordnung gemäß Figur 2A weist die Verstärkerschaltung 20' gemäß Figur 2B einen Koppelkondensator 28 auf, der den ersten Eingang 21 der Verstärkerschaltung 20' mit dem Eingang des Puffers 25 verbindet. Der zweite Eingang 22 der Verstärkerschaltung 20' ist ebenfalls am Eingang des Puffers 25 angeschlossen.

Dem Eingang des ersten Inverters 26 wird somit der Schwellwert Vth zugefüht, welcher in erster Näherung als Gleichspannung ausgebildet ist. Dieser Gleichspannung wird mittels des Koppelkondensators 28 die Oszillatorspannung Vosc beziehungsweise ein Anteil der Oszillatorspannung Vosc überlagert. Ausgangsseitig ist am ersten Inverter 26 ein Signal abgreifbar, das im Wesentlichen die Pegel Low und High aufweist, welche in Abhängigkeit von dem eingekoppelten Wechselspannungssignal und dem Schwellwert Vth gebildet werden. Der erste Inverter 26 weist einen Inverterschwellwert für den Übergang vom Pegel Low zum Pegel High auf. Steigt die Summe aus dem Schwellwert Vth und dem eingekoppelten Wechselspannungssignal über den Inverterschwellwert, so wird ausgangsseitig von dem ersten Inverter 26 der Wert Low und von dem nachgeschalteten zweiten Inverter 27 der Wert High ausgegeben, welcher gleichzeitig der Wert des Taktsignals Vout ist.

Es ist ein Vorteil der Verstärkerschaltung 20' gemäß Figur 2B, dass die Realisierung mittels eines ersten und eines zweiten Inverters 26, 27 einen sehr geringen Aufwand an Bauelementen benötigt.

Es ist ein Vorteil der Schaltungsanordnung 1 gemäß Figur 2B, dass das Tastverhältnis ϕ des Taktsignals Vout nahezu unabhängig von dem Inverterschwellwert des ersten Inverters 26 und einem Inverterschwellwert des zweiten Inverters 27 ist. Dies wird zum einen dadurch erreicht, dass die beiden Inverter 26, 27 hintereinander geschaltet sind und beispielsweise ein erhöhter Inverterschwellwert des ersten Inverters 26 durch einen erhöhten Inverterschwellwert des zweiten Inverters 27 ausgeglichen wird. Zum anderen wird mittels des Tiefpasses 40 und der Integratorschaltung 50 der Schwellwert Vth derart eingestellt, dass das gewünschte Tastverhältnis ϕ auch bei Abweichungen der Inverterschwellwerte von einem vorgesehenen Wert erzielt wird.

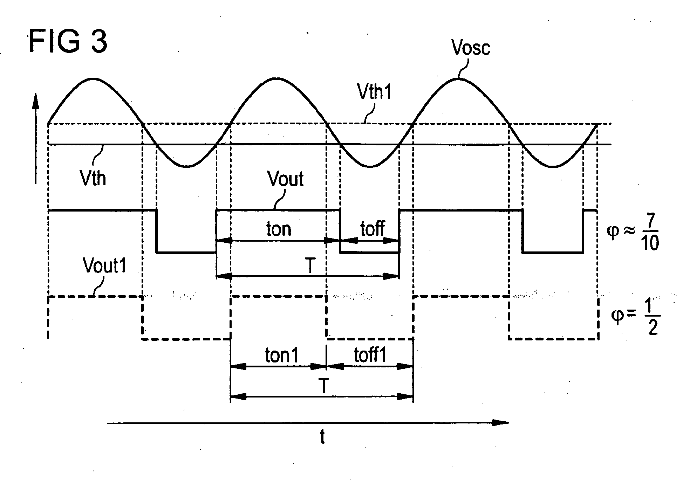

Figur 3 zeigt beispielhafte Signalverläufe in Abhängigkeit von der Zeit t, wie sie etwa in einer Schaltungsanordnung 1 gemäß den Figuren 1 und 2A abgreifbar sind. Sinkt die Oszillatorspannung Vosc unter den Schwellwert Vth, so weist das Taktsignal Vout den Pegel Low auf. Übersteigt hingegen die Oszillatorspannung Vosc den Schwellwert Vth, so weist das Taktsignal Vout den Pegel High auf. Der Pegel High liegt während einer Anschaltdauer ton und der Pegel Low während einer Ausschaltdauer toff an. Die Periodendauer T ist die Summe aus der Anschaltdauer ton und der Ausschaltdauer toff. Das Tastverhältnis ϕ beträgt in diesem Beispiel näherungsweise 0,7.

Es ist beispielhaft ein weiterer Schwellwert Vth1 und ein weiteres Taktsignal Vout1 gezeigt. Die weitere Anschaltdauer ton1 und die weitere Ausschaltdauer toff1 sind gleich, so dass das Tastverhältnis ϕ den Wert 0,5 aufweist.

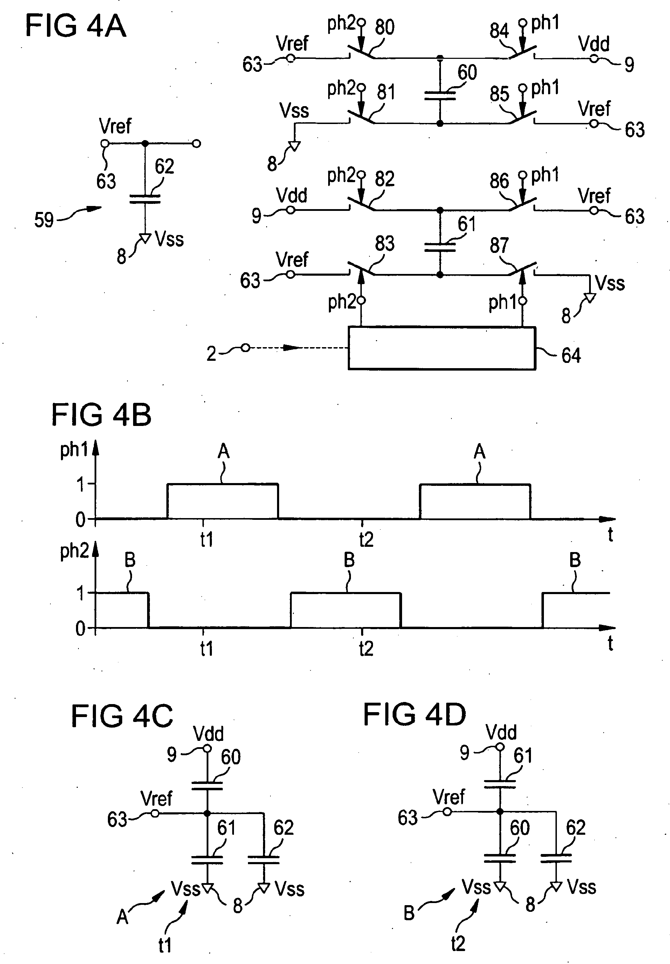

Figuren 4A bis 4D zeigen eine beispielhafte Ausführungsform der Gleichspannungsquelle 75, welche eine Switched-Capacitor-Schaltung 59 umfasst, wie sie anstelle des Spannungsteilers 55 in der Integratorschaltung 50 gemäß Figur 1 sowie gemäß Figuren 2A und 2B eingesetzt werden kann.

Figur 4A zeigt die Switched-Capacitor-Schaltung 59 zum Bereitstellen der Referenzspannung Vref, welche eine feste Spannung ist. Die Switched-Capacitor-Schaltung 59 umfasst einen ersten und einen zweiten Schaltkondensator 60, 61 sowie einen Haltekondensator 62. Der Haltekondensator 62 ist zwischen den Abgriff 63, an dem die Referenzspannung Vref bereitgestellt wird, und den Bezugspotenzialanschluss 8 geschaltet. Der Abgrifff 63 kann in einer Ausführungsform mit dem zweiten Eingang 53 des Transkonduktanz-Verstärkers 51 verbunden sein. Der erste Schaltkondensator 60 ist an einer ersten Elektrode in einer ersten Phase A über einen Schalter 84 mit dem Versorgungsspannungsanschluss 9 und an einer zweiten Elektrode über einen Transistor 85 mit dem Abgriff 63 verbunden. Der zweite Schaltkondensator 61 ist in der ersten Phase A an einer ersten Elektrode über einen Schalter 86 mit dem Abgriff 63 und an einer zweiten Elektrode über einen Schalter 87 mit dem Bezugspotenzialanschluss 8 verbunden. In einer zweiten Phase B ist die erste Elektrode des ersten Schaltkondensators 60 über einen Schalter 80 mit dem Abgriff 63 und an der zweiten Elektrode über einen Schalter 81 mit dem Bezugspotenzialanschluss 8 verbunden. Ebenfalls ist in der zweiten Phase B die erste Elektrode des zweiten Schaltkondensators 61 über einen Schalter 82 mit dem Versorgungsspannungsanschluss 9 und die zweite Elektrode über einen Schalter 83 mit dem Abgriff 63 verbunden. Weiter zeigt Figur 4A eine Steuerungsanordnung 64, die ausgangsseitig mit den Schaltern 84 bis 87 zur Zuführung eines ersten Phasensignals ph1 und mit den Schaltern 80 bis 83 zur Zuführung eines zweiten Phasensignals ph2 verbunden ist. Eingangsseitig ist die Steuerungsanordnung 64 mit dem Eingang 2 der Schaltungsanordnung 1 gekoppelt. Diese Kopplung ist zum Erzeugen der periodisch auftretenden Phasensignale ph1, ph2 mittels der Steuerungsanordnung 64 vorgesehen.

Jeweils einer der beiden Schaltkondensatoren 60, 61 wird somit in der einen Phase zwischen den Abgriff 63 und den Bezugspotenzialanschluss 8 und in der anderen Phase zwischen den Versorgungsspannungsanschluss 9 und den Abgriff 63 geschaltet. Es liegt somit bei einem der beiden Schaltkondensatoren 60, 61 die Differenz zwischen der Versorgungsspannung Vdd und der Referenzspannung Vref und am zweiten der beiden Schaltkondensatoren 60, 61 die Referenzspannung Vref an. Nach einigen Taktzyklen wird ein stabiler Wert für die Referenzspannung Vref bereitgestellt, der näherungsweise die Hälfte des Wertes der Versorgungsspannung Vdd beträgt. Dieser Wert der Referenzspannung Vref ist in erster Näherung unabhängig von den Werten der Kondensatoren 60, 61, 62.

Somit kann mit Vorteil eine Referenzspannung Vref bereitgestellt werden, die den Wert 1/2 aufweist, was einem Tastverhältnis von ebenfalls 1/2 entspricht. Mit Vorteil ist die am Abgriff 63 bereitgestellte Referenzspannung in erster Näherung von einer Frequenz unabhängig, mit der der erste und der zweite Schaltkondensator 60, 61 umgeschaltet werden.

Die Schalter 80 bis 87 können in einer Ausführungsform als Feldeffekttransistoren ausgebildet sein.

Figur 4B zeigt das erste und das zweite Steuersignal ph1, ph2. Ein Zeitpunkt t1 befindet sich in der ersten Phase A, während der das erste Phasensignal ph1 den logischen Wert High aufweist, und ein Zeitpunkt t2 befindet sich in der zweiten Phase B, während der das Phasensignal ph2 den logischen Wert High aufweist. Es sind Nichtüberlappungsphasen zwischen der ersten Phase A und der zweiten Phase B vorgesehen. Davon abgesehen wechseln sich die Phasen A, B periodisch ab. Mit Vorteil wird so ein Kurzschluss zwischen dem Versorgungsspannungsanschluss 9 und dem Abgriff 63 und ein Kurzschluss zwischen dem Abgriff 63 und dem Bezugspotenzialanschluss 8 vermieden.

Figur 4C zeigt die Schaltstellung der Switched-Capacitor-Schaltung 59 zu dem Zeitpunkt t1 während der ersten Phase A. Der erste Schaltkondensator 60 koppelt die Versorgungsspannung Vdd mit der Referenzspannung Vref, während der zweite Schaltkondensator 61 die Referenzspannung Vref mit dem Bezugspotenzial Vss koppelt.

Figur 4D zeigt die Schaltstellung der Switched-Capacitor-Schaltung 59 zu dem Zeitpunkt t2 während der zweiten Phase B. Der zweite Schaltkondensator 61 koppelt die Versorgungsspannung Vdd mit der Referenzspannung Vref, während der erste Schaltkondensator 60 die Referenzspannung Vref mit dem Bezugspotenzial Vss koppelt.

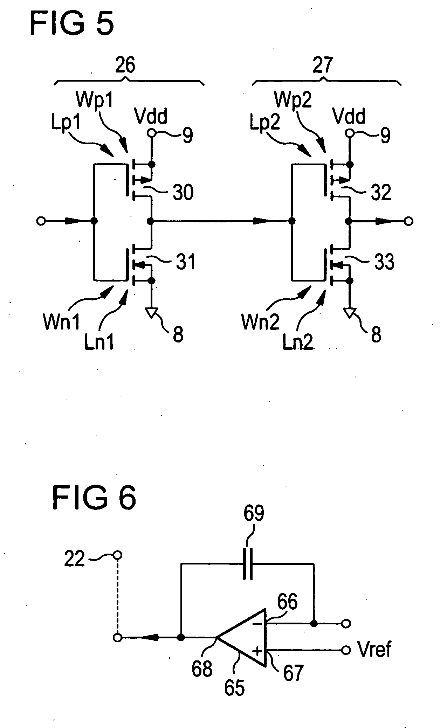

Figur 5 zeigt eine beispielhafte Ausführungsform eines Puffers 25, wie er in der Verstärkerschaltung 20 der Schaltungsanordnung 1 gemäß Figur 1, 2A und 2B eingesetzt werden kann. Der Puffer 25 weist einen ersten und einen zweiten Inverter 26, 27 auf. Der erste Inverter umfasst einen P-Kanal Feldeffekttransistor 30 und einen N-Kanal Feldeffekttransistor 31, die in Serie zueinander sowie zwischen den Versorgungsspannungsanschluss 9 und den Bezugspotenzialanschluss 8 geschaltet sind. Entsprechend weist der zweite Inverter 27 einen P-Kanal Feldeffekttransistor 32 und einen N-Kanal Feldeffekttransistor 33 auf, die in Serie zueinander und zwischen den Versorgungsspannungsanschluss 9 und den Bezugspotenzialanschluss 8 geschaltet sind. Die vier Transistoren 30 bis 33 sind als selbstsperrende Transistoren ausgebildet. Der P-Kanal Feldeffekttransistor 30 weist eine Kanalweite Wp1 und eine Kanallänge Lp1 auf. Entsprechend weist der P-Kanal Feldeffekttransistor 32 eine Kanalweite Wp2 und eine Kanallänge Lp2 sowie der N-Kanal Feldeffekttransistor 31 eine Kanalweite Wn1 und eine Kanallänge Ln1 und der N-Kanal Feldeffekttransistor eine Kanalweite Wn2 und eine Kanallänge Ln2 auf.

In einer Ausführungsform können die Kanalweiten Wp1, Wp2 und die Kanallängen Lp1 und Lp2 des P-Kanalfeldeffekttransistors 30 und des P-Kanalfeldeffekttransistors 32 näherungsweise die gleichen Werte aufweisen. Ebenfalls können in dieser Ausführungsform die Kanalweiten Wn1, Wn2 der beiden N-Kanal Feldeffekttransistoren 31, 33 und die Kanallängen Ln1, Ln2 der beiden N-Kanal Feldeffekttransistoren 31, 33 näherungsweise die gleichen Werte aufweisen. Gemäß dieser Ausführungsform ist die Stromtreiberfähigkeit des ersten Inverters 26 und des zweiten Inverters 27 näherungsweise gleich.

In einer anderen Ausführungsform ist das Verhältnis aus der Kanalweite Wp2 zur Kanallänge Lp2 des P-Kanal Feldeffekttransistors 32 größer als das Verhältnis der Kanallänge Wp1 und der Kanallänge Lp1 des P-Kanal Feldeffekttransistors 30. Entsprechend ist auch ein Verhältnis der Kanalweite Wn2 zu der Kanallänge Ln2 des Transistors 33 größer als ein Verhältnis der Kanalweite Wn1 zu der Kanallänge Ln1 des Transistors 31. Gemäß dieser alternativen Ausführungsform ist die Stromtreiberfähigkeit des zweiten Inverters 27 größer als die des ersten Inverters 26. Mit Vorteil können somit elektrische Lasten, die am Ausgang 4 der Schaltungsanordnung 1 angekoppelt sind, besser getrieben werden.

Figur 6 zeigt einen Operationsverstärker 65, wie er anstelle des Transkonduktanz-Verstärkers 51 in der Integratorschaltung 50 gemäß Figur 1, 2A und 2B einsetzbar ist. Ein invertierender Eingang 66 des Operationsverstärkers 65 ist über eine Rückkoppelkapazität 69 mit einem Ausgang 68 des Operationsverstärkers 65 verbunden. Der Ausgang 68 des Operationsverstärkers 65 ist über das in der Figur 6 nicht gezeigte Schleifenfilter 71 mit dem zweiten Eingang 22 der Verstärkerschaltung 20 gekoppelt. Der Tiefpass 40 ist ausgangsseitig mit dem invertierenden Eingang 66 verbunden. Ein nichtinvertierender Eingang 67 des Operationsverstärkers 65 ist mit dem Abgriff 63 der Switched-Capacitor-Schaltung 59 oder dem Abgriff zwischen den beiden Widerständen 56, 57 des Spannungsteilers 55 zur Zuleitung der Referenzspannung Vref an den Operationsverstärker 65 verbunden. Aufgrund der Rückkoppelkapazität 69 ist der Operationsverstärker 65 als integrierender Verstärker beschaltet.

In einer alternativen Ausführungsform ist der Operationsverstärker 65 ohne Zwischenschaltung des Schleifenfilters 71 mit dem zweiten Eingang 22 der Verstärkerschaltung 20 verbunden.

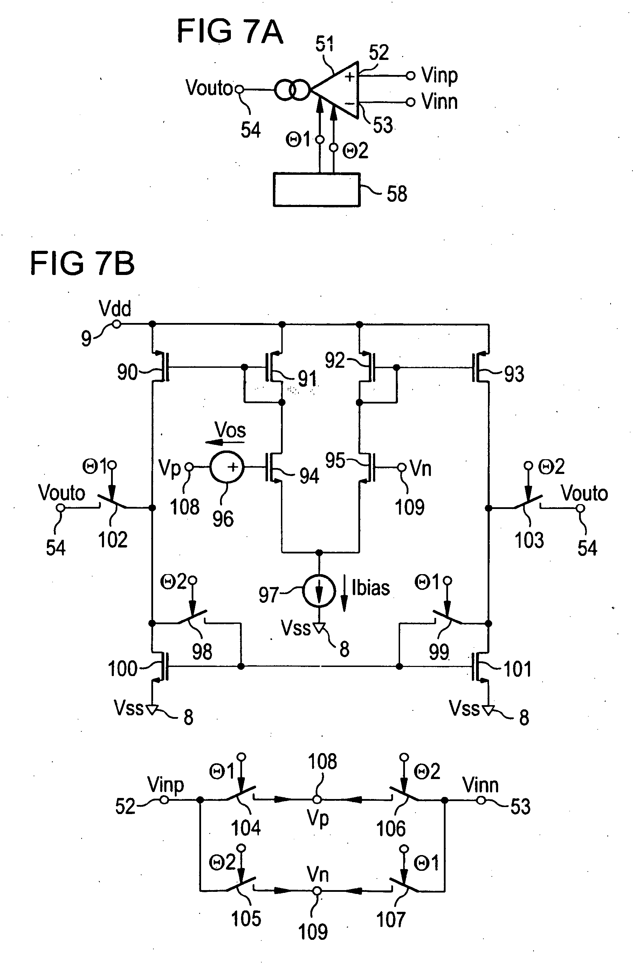

Figuren 7A bis 7B zeigen eine beispielhafte Ausführungsform eines getakteten Transkonduktanz-Verstärkers 51, wie er in der Integratorschaltung 50 gemäß den Figuren 1, 2A und 2B einsetzbar ist. Der Transkonduktanz-Verstärker 51 ist für den Chopper-Betrieb ausgelegt.

Figur 7A zeigt das Prinzipbild des Transkonduktanz-Verstärkers 61 mit dem ersten und dem zweiten Eingang 52, 53 zur Zuführung einer ersten und einer zweiten Eingangsspannung Vinn, Vinp. Der Transkonduktanz-Verstärker 51 ist mit zwei Ausgängen einer Steueranordnung 58 zur Zuführung eines ersten und eines zweiten Steuersignals Θ1, Θ2 verbunden. Ausgangsseitig ist am Transkonduktanz-Verstärker 51 eine Ausgangsspannung Vouto abgreifbar.

Figur 7B zeigt eine beispielhafte Ausführungsform des getakteten Transkonduktanz-Verstärkers 51. Der Transkonduktanz-Verstärker 51 weist einen Stromspiegel 90, 91 und einen weiteren Stromspiegel 92, 93 auf, die an einem Anschluss mit dem Versorgungspotenzialanschluss 9 verbunden sind. Der Transistor 90 ist über einen Transistor 100 mit dem Bezugspotenzialanschluss 8 verbunden. Entsprechend ist der Transistor 93 über einen Transistor 101 ebenfalls mit dem Bezugspotenzialanschluss 8 verbunden. Hingegen ist der Transistor 91 über einen Transistor 94 mit einem ersten Anschluss einer Stromquelle 97 verbunden. Der Transistor 92 ist über einen Transistor 109 ebenfalls mit dem ersten Anschluss der Stromquelle 97 verbunden. Ein Steueranschluss des Transistors 94 ist über eine Spannungsquelle 96 mit dem Abgriff 108 verbunden. Ein Steueranschluss des Transistors 95 ist mit dem Abgriff 109 verbunden. Die Abgriffe 108, 109 sind mit dem ersten und dem zweiten Eingang 52, 53 mittels der Schalter 104 bis 107 zur Zuführung der ersten und der zweiten Eingangsspannung Vinp, Vinn gekoppelt. Ein Abgriff zwischen dem Transistor 90 und dem Transistor 100 ist über einen Schalter 102 mit dem Ausgang 54 des Transkonduktanz-Verstärkers 51 gekoppelt. Entsprechend ist ein Abgriff zwischen dem Transistor 93 und dem Transistor 101 über einen Schalter 103 mit dem Ausgang 54 des Transkonduktanz-Verstärkers 51 gekoppelt. Ein Steueranschluss des Transistors 100 ist mit einem Steueranschluss des Transistors 101 verbunden. Über einen Schalter 98 sind die beiden Steueranschlüsse mit dem Abgriff zwischen den Transistoren 90, 100 gekoppelt. Ebenfalls sind die beiden Steueranschlüsse über einen Schalter 99 mit dem Abgriff zwischen den Transistoren 93, 101 gekoppelt.

Während das erste Steuersignal Θ1 den Pegel "High" annimmt, wird die erste Eingangsspannung Vinp mittels des Schalters 104 dem Abgriff 108 und die zweite Eingangsspannung Vinn über den Schalter 107 dem Abgriff 109 zugeleitet. Dahingegen wird, während das zweite Steuersignal Θ2 den Pegel "High" annimmt, die erste Eingangsspannung Vinp über den Schalter 105 dem Abgriff 109 und die zweite Eingangsspannung Vinn über den Schalter 106 dem Abgriff 108 zugeführt.

Während das erste Steuersignal Θ1 den Pegel "High" annimmt, sind auch die Schalter 99, 102 in einem geschlossen Betriebszustand. Während das zweite Steuersignal Θ2 den Pegel "High" annimmt, sind die Schalter 98, 103 in einem geschlossenen Betriebszustand. Somit werden eingangsseitig und ausgangsseitig derartig die Anschlüsse umgeschaltet, dass nach einer Glättung durch einen Tiefpass, welcher am Ausgang 54 angeschlossen ist, ein Schwellwert Uth am Ausgang der Integratorschaltung 50 abgreifbar ist, welcher in erster Näherung unabhängig von einem Offset des Transkonduktanz-Verstärkers 51 ist.

### Bezugszeichenliste

- 1: Schaltungsanordnung
- 2: Eingang
- 3: Oszillator
- 4: Ausgang
- 8: Bezugspotentialanschluss
- 9: Versorgungsspannungsanschluss
- 10: Schwingquarz
- 11: erster Kondensator
- 12: zweiter Kondensator
- 13: Widerstand
- 14, 15: Transistor
- 20: Verstärkerschaltung
- 21: erster Eingang
- 22: zweiter Eingang
- 23: Ausgang
- 24: Komparator
- 25: Puffer
- 26: erster Inverter
- 27: zweiter Inverter
- 28: Koppelkondensator
- 30, 32: p-Kanal Feldeffekttransistor
- 31, 33: n-Kanal Feldeffekttransistor
- 40: Tiefpass
- 41: Widerstand
- 42: Kondensator
- 50: Integratorschaltung
- 51: Transkonduktanz-Verstärker
- 52: erster Eingang
- 53: zweiter Eingang
- 54: Ausgang
- 55: Spannungsteiler
- 56: erster Widerstand
- 57: zweiter Widerstand
- 58: Steuerungsanordnung
- 59: Switched Capacitor Schaltung
- 60: erster Schaltkondensator
- 61: zweiter Schaltkondensator
- 62: Haltekondensator
- 63: Abgriff
- 64: Steuerungsanordnung
- 65: Operationsverstärker
- 66: invertierender Eingang
- 67: nichtinvertierender Eingang
- 68: Ausgang
- 69: Rückkoppelkapazität
- 71: Schleifenfilter
- 72: zweiter Kondensator
- 73: erster Widerstand
- 74: erster Kondensator
- 75: Gleichspannungsquelle
- 80 bis 87: Schalter
- 90 bis 95: Transistor
- 96: Spannungsquelle
- 97: Stromquelle
- 98, 99: Schalter
- 100, 101: Transistor
- 102 bis 107: Schalter
- ϕ: Tastverhältnis
- θ1: erstes Steuersignal
- θ2: zweites Steuersignal
- A: erste Phase
- B: zweite Phase
- Ibias: Stromquellenstrom
- ph1, ph2: Phasensignal
- t: Zeit
- T: Periodendauer
- ton: Anschaltdauer
- ton1 weitere: Anschaltdauer
- toff: Ausschaltdauer
- toff1: weitere Ausschaltdauer
- t1, t2: Zeitpunkt
- Vdd: Versorgungsspannung
- Vinn: zweite Eingangsspannung
- Vinp: erste Eingangsspannung
- Vn, Vp: Eingangsspannung
- Vout: Taktsignal
- Vout1: weiteres Taktsignal
- Vouto: Ausgangsspannung
- Vosc: Oszillatorspannung
- Vref: Referenzspannung
- Vss: Bezugspotential
- Vth: Schwellwert
- Vth1: weiterer Schwellwert

## Patentansprüche

1. Schaltungsanordnung zum Bereitstellen eines Taktsignals mit einem einstellbaren Tastverhältnis, umfassend
- einen Eingang (2) zum Anschließen eines Oszillator (3),
- eine Verstärkerschaltung (20)
- mit einem ersten Eingang (21), der mit dem Eingang (1) der Schaltungsanordnung (1) gekoppelt ist,
- mit einem zweiten Eingang (22),
- mit einem Komparator (24), dessen Eingänge den ersten und den zweiten Eingang (21, 22) der Verstärkerschaltung (20) bilden, und
- mit einem Puffer (25), der zumindest einen ersten Inverter (26) aufweist und einen Ausgang des Komparators (24) mit einem Ausgang (23) der Verstärkerschaltung (20) koppelt,
- einen Ausgang (4), der mit dem Ausgang (23) der Verstärkerschaltung (20) verbunden und an dem ein Taktsignal (Vout) mit einem Tastverhältnis (ϕ) abgreifbar ist,
- einen Tiefpass (40), der eingangsseitig mit dem Ausgang (23) der Verstärkerschaltung (20) verbunden ist, und
- eine Integratorschaltung (50), die eingangsseitig mit dem Tiefpass (40) und ausgangsseitig mit dem zweiten Eingang (22) der Verstärkerschaltung (20) zur Abgabe eines vorgebbaren Schwellwertes (Vth) zur Steuerung des Tastverhältnisses (ϕ) verbunden ist,
wobei die Integratorschaltung (50) ein Schleifenfilter (71) aufweist, welches am Ausgang der Integratorschaltung .(50) angeschlossen ist,
das Schleifenfilter (71) einen ersten Kondensator (74) umfasst, welches den Ausgang der Integratorschaltung (50) mit dem Bezugspotentialanschluss (8) verbindet, und das Schleifenfilter (71) eine Serienschaltung, umfassend einen Widerstand (73) und einen zweiten Kondensator (72), aufweist, welche den Ausgang der Integratorschaltung (50) mit dem Bezugspotentialanschluss (8) verbindet.

2. Schaltungsanordnung nach Anspruch 1,
**dadurch gekennzeichnet, dass**
der Puffer (25) einen zweiten Inverter (27) umfasst, wobei der zweite Inverter (27) dem ersten Inverter (26) nachgeschaltet und die Stromtreiberfähigkeit des zweiten Inverters (27) größer als die Stromtreiberfähigkeit des ersten Inverters (26) ist .

3. Schaltungsanordnung nach Anspruch 1 oder 2,
**dadurch gekennzeichnet, dass**
die Integratorschaltung (50) einen Transkonduktanz-Verstärker (51) umfasst,
- der an einem ersten Eingang (52) mit dem Tiefpass (40) verbunden ist,
- dem an einem zweiten Eingang (53) eine Referenzspannung (Vref) zuleitbar ist und
- der an einem Ausgang (54) mit dem zweiten Eingang (22) der Verstärkerschaltung (20) gekoppelt ist.

4. Schaltungsanordnung nach Anspruch 3,
**dadurch gekennzeichnet, dass** der Transkonduktanz-Verstärker (51) für einen Chopper-Betrieb ausgelegt ist.

5. Schaltungsanordnung nach Anspruch 1 oder 2,
**dadurch gekennzeichnet, dass**
die Integratorschaltung (50) einen Operationsverstärker (65) umfasst,
- der an einem invertierenden Eingang (66) mit dem Tiefpass (40) verbunden ist,
- dem an einem nichtinvertierenden Eingang (67) eine Referenzspannung (Vref) zuleitbar ist und
- der an einem Ausgang (68) mit dem zweiten Eingang (22) der Verstärkerschaltung (20) sowie über einen Rückkoppelkondensator (69) mit dem invertierendem Eingang (66) gekoppelt ist.

6. Schaltungsanordnung nach einem der Ansprüche 3 bis 5,
**dadurch gekennzeichnet, dass**
die Integratorschaltung (50) eine Gleichspannungsquelle (75) umfasst, die einen Abgriff aufweist, an dem die Referenzspannung (Vref) abgreifbar ist.

7. Schaltungsanordnung nach Anspruch 6,
**dadurch gekennzeichnet, dass**
die Gleichspannungsquelle (75) der Integratorschaltung (50) einen Spannungsteiler (55) mit einem ersten und einem zweiten Widerstand (56, 57) umfasst, der zwischen einen Versorgungsspannungsanschluss (9) und einen Bezugspotentialanschluss (8) geschaltet ist und einen Abgriff aufweist, an dem die Referenzspannung (Vref) abgreifbar ist und der mit dem zweiten Eingang (53) des Transkonduktanz-Verstärkers (51) beziehungsweise dem nichtinvertierenden Eingang (67) des Operationsverstärkers (65) verbunden ist.

8. Schaltungsanordnung nach Anspruch 7,
**dadurch gekennzeichnet, dass**
der erste Widerstand (56) als Widerstandsnetzwerk mit mehreren Abgriffen ausgebildet ist, zwischen denen umgeschaltet werden kann, und/oder der zweite Widerstand (57) als Widerstandsnetzwerk mit mehreren Abgriffen ausgebildet ist, zwischen denen umgeschaltet werden kann, derart dass die Referenzspannung (Vref) zwischen verschiedenen Werten zur Einstellung des Schwellwertes (Vth) umschaltbar ist.

9. Schaltungsanordnung nach Anspruch 6,
**dadurch gekennzeichnet, dass**
die Gleichspannungsquelle (75) der Integratorschaltung (50) eine Switched Capacitor Schaltung (59) mit einem ersten und einem zweiten Schaltkondensator (60, 61) und mit einem Abgriff (63) umfasst, der mit dem zweiten Eingang (53) des Transkonduktanz-Verstärkers (51) beziehungsweise dem nichtinvertierenden Eingang (72) des Operationsverstärkers (70) und über einen Haltekondensator (62) mit einem Bezugspotentialanschluss (8) verbunden ist und an dem die Referenzspannung (Vref) abgreifbar ist.

10. Schaltungsanordnung nach Anspruch 9,
**dadurch gekennzeichnet, dass**
- in einer ersten Phase (A) der erste Schaltkondensator (60) zwischen einen Versorgungsspannungsanschluss (9) und den Abgriff (63) und der zweite Schaltkondensator (61) zwischen den Abgriff (63) und den Bezugspotentialanschluss (8) geschaltet ist und
- in einer zweiten Phase (B) der erste Schaltkondensator (60) zwischen den Abgriff (63) und den Bezugspotentialanschluss (8) und der zweite Schaltkondensator (61) zwischen den Versorgungsspannungsanschluss (9) und den Abgriff (63) geschaltet ist, wobei die erste und die zweite Phase (A, B) periodisch abwechseln.

11. Schaltungsanordnung nach einem der Ansprüche 1 bis 10,
**dadurch gekennzeichnet, dass**
der Tiefpass (40) einen Widerstand (41), der einen Eingang des Tiefpasses (40) mit einem Ausgang des Tiefpasses (40) verbindet, und einen Kondensator (42), der den Ausgang des Tiefpasses (40) mit einem Bezugspotentialanschluss (8) verbindet, umfasst.

12. Verwendung der Schaltungsanordnung (1) nach einem der Ansprüche 1 bis 11 in einem Mikroprozessor-Schaltkreis oder einem Halbleiterspeicher.

13. Verfahren zum Bereitstellen eines Taktsignals mit einem einstellbarem Tastverhältnis,
umfassend folgende Schritte:
- Zuführen eines Oszillatorsignals (Vosc),
- Vergleichen des Oszillatorsignals (Vosc) mit einem Schwellwert (Vth), Verstärken des Vergleichsergebnisses und Bereitstellen des verstärkten Vergleichsergebnisses als das Taktsignal (Vout) mit dem Tastverhältnis (ϕ),
- Bereitstellen eines vom Tastverhältnis (ϕ) abgeleiteten Signals,
- Vergleichen des vom Tastverhältnis (ϕ) abgeleiteten Signals und einer vorgebbaren Referenzspannung (Vref) und Bereitstellen des Schwellwerts (Vth) in Abhängigkeit vom Vergleichsergebnis,
wobei eine Integratorschaltung (50) einen Transkonduktanz-Verstärker (51) und ein Schleifenfilter (71) umfasst, die Integratorschaltung (50) ausgangsseitig den Schwellwert (Vth) in Abhängigkeit von einem Strom an einem Ausgang (54) des Transkonduktanz-Verstärkers (51) und von einer Filtercharakteristik des Schleifenfilters (71) bereitstellt und das Schleifenfilter (71) einen ersten Kondensator (74) umfasst, der parallel zu einer Serienschaltung, aufweisend einen zweiten Kondensator (72) und einen ersten Widerstand (73), zwischen den Ausgang (54) des Transkonduktanz-Verstärkers (51) und einen Bezugspotentialanschluss (8) geschaltet ist.

## Claims

1. A circuit arrangement for providing a clock signal with an adjustable duty ratio, comprising
- an input (2) for connecting an oscillator (3),
- an amplifier circuit (20)
- having a first input (21) coupled to the input (2) of the circuit arrangement (1),
- having a second input (22),
- having a comparator (24) the inputs of which constitute the first and second inputs (21, 22) of the amplifier circuit (20), and
- having a buffer (25) which comprises at least a first inverter (26) and couples an output of the comparator (24) to an output (23) of the amplifier circuit (20),
- an output (4) which is connected to the output (23) of the amplifier circuit (20) and at which a clock signal (Vout) with a duty ratio (ϕ) may be tapped,
- a low-pass element (40) which has its input side connected to the output (23) of the amplifier circuit (20), and
- an integrator circuit (50) which has its input side connected to the low-pass element (40) and has its output side connected to the second input (22) of the amplifier circuit (20) for delivering a predefinable threshold value (Vth) for controlling the duty ratio (ϕ),
the integrator circuit (50) comprising a loop filter (71) connected to the output of the integrator circuit (50),
the loop filter (71) comprising a first capacitor (74) connecting the output of the integrator circuit (50) to the reference potential terminal (8), and the loop filter (71) comprising a series connection comprising a resistor (73) and a second capacitor (72) and connecting the output of the integrator circuit (50) to the reference potential terminal (8).

2. The circuit arrangement according to claim 1,
**characterized in that**
the buffer (25) comprises a second inverter (27) arranged downstream of the first inverter (26), the current driving ability of the second inverter (27) being larger than that of the first inverter (26).

3. The circuit arrangement according to claim 1 or 2,
**characterized in that**
the integrator circuit (50) comprises a transconductance amplifier (51),
- which is connected to the low-pass element (40) at a first input (52),
- which may be fed with a reference voltage (Vref) at a second input (53) and
- which is coupled to the second input (22) of the amplifier circuit (20) at an output (54).

4. The circuit arrangement according to claim 3, **characterized in that** the transconductance amplifier (51) is designed for a chopper operation.

5. The circuit arrangement according to claim 1 or 2,
**characterized in that**
the integrator circuit (50) comprises an operation amplifier (65)
- which is connected to the low-pass element (40) at an inverting input (66),
- which may be fed with a reference voltage (Vref) at a non-inverting input (67), and
- which is coupled to the second input (22) of the amplifier circuit (20) at an output (68) and to the inverting input (66) via a feedback capacitor (69) at the output (68).

6. The circuit arrangement according to any of the claims 3 to 5,
**characterized in that**
the integrator circuit (50) comprises a DC voltage source (75) with a tap point where the reference voltage (Vref) may be tapped.

7. The circuit arrangement according to claim 6,
**characterized in that**
the DC voltage source (75) of the integrator circuit (50) comprises a voltage divider (55) which has first and second resistors (56, 57) and is inserted between a supply voltage terminal (9) and a reference potential terminal (8) and has a tap point where the reference voltage (Vref) may be tapped, and which is connected to the second input (53) of the transconductance amplifier (51) and the non-inverting input (67) of the operation amplifier (65), respectively.

8. The circuit arrangement according to claim 7,
**characterized in that**
the first resistor (56) is realized as a resistor network with several tap points between which a changeover may occur, and/or the second resistor (57) is realized as a resistor network with several tap points between which a changeover may occur, in such a manner that the reference voltage (Vref) may be shifted between different values for adjusting the threshold value (Vth).

9. The circuit arrangement according to claim 6,
**characterized in that**
the DC voltage source (75) of the integrator circuit (50) comprises a switched capacitor circuit (59) with first and second switch capacitors (60, 61) and with a tap point (63) which is connected to the second input (53) of the transconductance amplifier (51) or the non-inverting input (72) of the operation amplifier (70) respectively, and is connected to a reference potential terminal (8) via a holding capacitor (62) and at which the reference voltage (Vref) may be tapped.

10. The circuit arrangement according to claim 9,
**characterized in that**
- in a first phase (A), the first switch capacitor (60) is inserted between a supply voltage terminal (9) and the tap point (63) as well as the second switch capacitor (61) is inserted between the tap point (63) and the reference potential terminal (8) and
- in a second phase (B), the first switch capacitor (60) is inserted between the tap point (63) and the reference potential terminal (8) as well as the second switch capacitor (61) is inserted between the supply voltage terminal (9) and the tap point (63), the first and second phases (A, B) alternating periodically.

11. The circuit arrangement according to any of the claims 1 to 10,
**characterized in that**
the low-pass element (40) comprises a resistor (41) connecting an input of the low-pass element (40) to an output of the low-pass element (40), and a capacitor (42) connecting the output of the low-pass element (40) to a reference potential terminal (8).

12. Use of the circuit arrangement (1) according to any of the claims 1 to 11 in a microprocessor circuitry or a semiconductor memory.

13. A method for providing a clock signal with an adjustable duty ratio,
comprising the following steps:
- supplying an oscillator signal (Vosc),
- comparing the oscillator signal (Vosc) with a threshold value (Vth), amplifying the result of the comparison and providing the amplified result of the comparison as the clock signal (Vout) with the duty ratio (ϕ),
- providing a signal derived from the duty ratio (ϕ),
- comparing the signal derived from the duty ratio (ϕ) and a predefinable reference voltage (Vref), and providing the threshold value (Vth) depending on the result of the comparison,
an integrator circuit (50) comprising a transconductance amplifier (51) and a loop filter (71), the integrator circuit (50) providing at its output side the threshold value (Vth) depending on a current at an output (54) of the transconductance amplifier (51) and depending on filter characteristics of the loop filter (71), and the loop filter (71) comprising a first capacitor (74) which is inserted between the output (54) of the transconductance amplifier (51) and a reference potential terminal (8) and provided parallel to a series connection comprising a second capacitor (72) and a first resistor (73).

## Revendications

1. Montage de circuits destiné à fournir un signal d'horloge avec un rapport cyclique réglable, comportant :
- une entrée (2) servant à connecter un oscillateur (3),
- un circuit amplificateur (20)
- incluant une première entrée (21) qui est couplée à l'entrée (1) du montage de circuits (1),
- incluant une seconde entrée (22),
- incluant un comparateur (24) dont les entrées constituent la première et la seconde entrée (21, 22) du circuit amplificateur (20), et
- incluant un organe tampon (25) qui présente au moins un premier inverseur (26) et qui couple une sortie du comparateur (24) à une sortie (23) du circuit amplificateur (20),
- une sortie (4) qui est reliée à la sortie (23) du circuit amplificateur (20) et sur laquelle un signal d'horloge (Vout) avec un rapport cyclique (ϕ) peut être prélevé,
- un filtre passe-bas (40) qui est relié du côté de l'entrée à la sortie (23) du circuit amplificateur (20), et
- un circuit intégrateur (50) qui est relié du côté de l'entrée au filtre passe-bas (40) et du côté de la sortie à la seconde entrée (22) du circuit amplificateur (20) afin de transmettre une valeur seuil prédéfinissable (Vth) pour la commande du
rapport cyclique (ϕ),
le circuit intégrateur (50) présentant un filtre à boucle (71) qui est connecté à la sortie du circuit intégrateur (50),
le filtre à boucle (71) comportant un premier condensateur (74) qui relie la sortie du circuit intégrateur (50) au raccord de potentiel de référence (8), et le filtre à boucle (71) présentant un circuit en série qui comporte une résistance (73) et un second condensateur (72) et qui relie la sortie du circuit intégrateur (50) au raccord de potentiel de référence (8).

2. Montage de circuits selon la revendication 1,
**caractérisé en ce que**
l'organe tampon (25) comporte un second inverseur (27), le second inverseur (27) étant monté en aval du premier inverseur (26) et la capacité de commande de courant du second inverseur (27) étant plus grande que la capacité de commande de courant du premier inverseur (26).

3. Montage de circuits selon la revendication 1 ou 2,
**caractérisé en ce que**
le circuit intégrateur (50) comporte un amplificateur à transconductance (51)
- qui, sur une première entrée (52), est relié au filtre passe-bas (40),
- auquel, sur une seconde entrée (53), une tension de référence (Vref) peut être transmise, et
- qui, sur une sortie (54), est couplé à la seconde entrée (22) du circuit amplificateur (20).

4. Montage de circuits selon la revendication 3, **caractérisé en ce que** l'amplificateur à transconductance (51) est conçu pour un fonctionnement de découpeur.

5. Montage de circuits selon la revendication 1 ou 2,
**caractérisé en ce que**
le circuit intégrateur (50) comporte un amplificateur opérationnel (65)
- qui, sur une entrée inverseuse (66), est relié au filtre passe-bas (40),
- auquel, sur une entrée non inverseuse (67), une tension de référence (Vref) peut être transmise, et
- qui, sur une sortie (68), est couplé à la seconde entrée (22) du circuit amplificateur (20) ainsi que, via un condensateur de rétroaction (69), à l'entrée inverseuse (66).

6. Montage de circuits selon l'une des revendications 3 à 5,
**caractérisé en ce que**
le circuit intégrateur (50) comporte une source de courant continu (75) qui présente une prise sur laquelle la tension de référence (Vref) peut être prélevée.

7. Montage de circuits selon la revendication 6,
**caractérisé en ce que**
la source de courant continu (75) du circuit intégrateur (50) comporte un diviseur de tension (55) avec une première et une seconde résistance (56, 57), lequel est monté entre un raccord de tension d'alimentation (9) et un raccord de potentiel de référence (8) et présente une prise sur laquelle la tension de référence (Vref) peut être prélevée et qui est reliée à la seconde entrée (53) de l'amplificateur à transconductance (51) ou respectivement à l'entrée non inverseuse (67) de l'amplificateur opérationnel (65).

8. Montage de circuits selon la revendication 7,
**caractérisé en ce que**
la première résistance (56) est constituée comme réseau de résistances comportant plusieurs prises entre lesquelles il est possible de commuter, et/ou la seconde résistance (57) est constituée comme réseau de résistances comportant plusieurs prises entre lesquelles il est possible de commuter, de telle façon que la tension de référence (Vref) est commutable entre diverses valeurs pour le réglage de la valeur seuil (Vth).

9. Montage de circuits selon la revendication 6,
**caractérisé en ce que**
la source de tension continue (75) du circuit intégrateur (50) comporte un circuit de capacité commutée (59) incluant un premier et un second condensateur de commutation (60, 61) et incluant une prise (63) qui est reliée à la seconde entrée (53) de l'amplificateur à transconductance (51) ou respectivement à l'entrée non inverseuse (72) de l'amplificateur opérationnel (70) ainsi que, via un condensateur de maintien (62), à un raccord de potentiel de référence (8) et sur laquelle la tension de référence (Vref) peut être prélevée.

10. Montage de circuits selon la revendication 9,
**caractérisé en ce que**
- dans une première phase (A), le premier condensateur de commutation (60) est monté entre un raccord de tension d'alimentation (9) et la prise (63), et le second condensateur de commutation (61) entre la prise (63) et le raccord de potentiel de référence (8), et
- dans une seconde phase (B), le premier condensateur de commutation (60) est monté entre la prise (63) et le raccord de potentiel de référence (8), et le second condensateur de commutation (61) entre le raccord de tension d'alimentation (9) et la prise (63), la première et la seconde phase (A, B) alternant périodiquement.

11. Montage de circuits selon l'une des revendications 1 à 10,
**caractérisé en ce que**
le filtre passe-bas (40) comporte une résistance (41) qui relie une entrée du filtre passe-bas (40) à une sortie du filtre passe-bas (40), et un condensateur (42) qui relie la sortie du filtre passe-bas (40) à un raccord de potentiel de référence (8).

12. Utilisation du montage de circuits (1) selon l'une des revendications 1 à 11 dans un circuit de commutation à microprocesseur ou dans une mémoire à semiconducteurs.

13. Procédé permettant de fournir un signal d'horloge avec un rapport cyclique réglable, comportant les étapes suivantes :
- admission d'un signal d'oscillateur (Vosc),
- comparaison du signal d'oscillateur (Vosc) avec une valeur seuil (Vth), amplification du résultat de la comparaison et fourniture du résultat amplifié de la comparaison comme signal d'horloge (Vout) avec le rapport cyclique (ϕ),
- fourniture d'un signal dérivé du rapport cyclique (ϕ),
- comparaison du signal dérivé du rapport cyclique (ϕ) et d'une tension de référence prédéfinissable (Vref) et fourniture de la valeur seuil (Vth) en fonction du résultat de la comparaison,
un circuit intégrateur (50) comportant un amplificateur à transconductance (51) et un filtre à boucle (71), le circuit intégrateur (50) fournissant du côté de la sortie la valeur seuil (Vth) en fonction d'un courant sur une sortie (54) de l'amplificateur à transconductance (51) et d'une caractéristique de filtrage du filtre à boucle (71), et le filtre à boucle comportant un premier condensateur (74) qui est monté, parallèlement à un circuit en série présentant un second condensateur (72) et une première résistance (73), entre la sortie (54) de l'amplificateur à transconductance (51) et un raccord de potentiel de référence (8).
